Europäisches Patentamt

European Patent Office

Office européen des brevets

(19)

(11) Numéro de publication: **0 013 345**
**B1**

(12) **FASCICULE DE BREVET EUROPEEN**

(45) Date de publication du fascicule du brevet: **15.09.82**

(21) Numéro de dépôt: **79104889.5**

(22) Date de dépôt: **04.12.79**

(51) Int. Cl.³: **B 23 K 26/00,
B 23 K 26/12,
B 23 K 26/08, H 01 L 21/60**

(54) Procédé et dispositif pour fixer des microplaquettes par radiations.

(30) Priorité: **29.12.78 US 974595**

(43) Date de publication de la demande:
**23.07.80 Bulletin 80/15**

(45) Mention de la délivrance du brevet:
**15.09.82 Bulletin 82/37**

(84) Etats contractants désignés:
**DE FR GB**

(56) Documents cités:
**IEEE JOURNAL OF SOLID-STATE CIRCUITS, vol.
SC-10, no. 4, août 1975,
New York USA,
L. KUHN et al.: "Experimental study of laser
formed connections for LSI wafer
personalization", pages 219—228.**

**IBM TECHNICAL DISCLOSURE BULLETIN, vol.
16, no. 9, janvier 1974,
New York USA,
G. L. HUTCHINS: "Localized semiconductor
diffusions utilizing local laser melting in doping
atmospheres", pages 2585—2586.**

(73) Titulaire: **International Business Machines
Corporation
Armonk, N.Y. 10504 (US)**

(72) Inventeur: **Tan, Swie-in
44 South Church Street
Bedford Hills, New York 10507 (US)**

(74) Mandataire: **Gallois, Gérard
COMPAGNIE IBM FRANCE Département de
Propriété Industrielle
F-06610 - La Gaude (FR)**

Courier Press, Leamington Spa, England.

## Procédé et dispositif pour fixer des microplaquettes par radiations.

Domaine technique

La présente invention concerne les procédés et dispositifs pour le travail du métal et, plus particulièrement, les procédés et dispositifs pour assembler des microplaquettes de circuits intégrés dans un ensemble, par exemple pour réparer cet ensemble.

Etat de la technique antérieure

Dans les ensembles de microplaquettes réalisés par intégration à grande échelle et dans lesquels les liaisons sont réalisées au moyen de billes de soudure, il était jusqu'à présent nécessaire, pour remplacer une microplaquette défectueuse, de retirer cette dernière, d'éliminer par des moyens mécaniques la soudure restante, de mettre en place une nouvelle microplaquette et de soumettre l'ensemble à une technique classique de soudure par refusion qui consiste notamment à chauffer ledit ensemble, y compris toutes les microplaquettes qu'il comporte. Ce processus s'est révélé indésirable dans de nombreux cas car l'étape de chauffage a pour effet d'endommager les microplaquettes qui ne comportent aucun défaut et n'ont donc pas à être remplacées.

Le brevet des E.U.A. No. 3 735 911 décrit un dispositif qui permet d'obtenir une chaleur infrarouge au moyen d'une flamme et qui comprend un détecteur de température infrarouge pour contrôler la température de la microplaquette chauffée, commandant l'extinction de la flamme dès que la température de la microplaquette dépasse une valeur déterminée.

Le brevet des E.U.A. No. 3 402 460 décrit un procédé de chauffage direct, au moyen d'un laser, des conducteurs et d'une région exposée de type p ou de type n à laquelle les conducteurs doivent être liés. Le faisceau laser frappe directement les conducteurs et une région en silicium dopé d'un dispositif semi-conducteur, chauffant ainsi les conducteurs de manière à les lier par fusion au silicium. La longueur d'onde choisie du laser est de 10600 Å (laser au néodyme) de manière à produire une lumière d'une longueur d'onde d'environ 11000 Å, qui est la longueur d'onde critique du silicium à laquelle le coefficient d'absorption de celui-ci est relativement faible, si bien que l'énergie du faisceau laser traverse le silicium et ne se concentre pas à la surface de la microplaquette en silicium, afin d'éviter d'endommager celle-ci thermiquement parce que la chaleur pénètre en profondeur dans le silicium plutôt que de se concentrer à sa surface.

Le brevet des E.U.A. No. 3 614 832 décrit également un procédé permettant de souder des conducteurs à une microplaquette au moyen d'un faisceau laser en dirigeant ce dernier vers la partie supérieure de la microplaquette, ce qui permet de réunir une bande conductrice, un conducteur et des contacts métalliques en utilisant une technique de soudure par refusion faisant appel à l'emploi d'une soudure composée de 90% de plomb et de 10% d'étain, le plomb et le contact étant préalablement revêtus d'une soudure à base d'étain. Le type de laser employé n'est pas décrit.

Le brevet des E.U.A. No. 3 970 819 décrit une technique consistant à chauffer la partie arrière d'une microplaquette semi-conductrice au moyen d'un faisceau laser afin de diminuer la résistance de la microplaquette à la rupture et de pouvoir la fragmenter en différents morceaux représentant des dispositifs individuels.

Le brevet des E.U.A. No. 3 934 073 décrit une technique d'utilisation d'un faisceau laser pour lier un conducteur à une microplaquette, ledit conducteur étant soutenu par un substrat en verre que doit traverser le faisceau laser, en l'occurrence un laser rouge au rubis Korad, pour atteindre le conducteur. Aucune allusion n'est faite à un substrat opaque, à une application à la partie arrière de la microplaquette, etc.

Le brevet des E.U.A. No. 3 435 186 décrit l'usinage de la partie arrière d'un objet au moyen d'un laser, mais en l'occurrence le substrat est transparent et le revêtement est opaque.

Le brevet des E.U.A. No. 3 485 996 décrit un procédé consistant à faire traverser un substrat transparent par une lumière laser afin de chauffer les parties métalliques et de les souder aux bandes conductrices d'un substrat et d'une microplaquette, le laser étant commandé en réaction en fonction du métal frappé par le faisceau, à savoir de l'or ou de l'alumine.

Un article de Lever intitulé "Applying Radiant Heat to Semiconductor Integrated Circuits" paru dans la publication "IBM Technical Disclosure Bulletin", vol. 20, pages 3908 et 3909, Mars 1978, décrit une technique consistant à exposer la partie arrière d'un substrat à une radiation lumineuse d'une longueur d'onde inférieure à 1,1 micron, soit en disposant un filtre entre une source incandescente et une microplaquette, soit en utilisant une source lumineuse telle qu'un laser dans la région visible ou du proche infrarouge du spectre.

Un article de D. Giacomo et al. intitulé "Prevention of Land Opens During Infrared Rework of Chips", paru dans la publication "IBM Technical Disclosure Bulletin", vol. 20, No. 8, pages 3216 et 3217, Janvier 1978, décrit une technique consistant à chauffer une microplaquette au moyen d'une source de radiation, la partie du spectre dont la longueur d'onde est supérieure à 1 micron étant filtrée de telle sorte que seule la lumière dont la longueur d'onde est comprise entre 0,25 et 1 micron puisse irradier la microplaquette.

## Exposé de l'invention

La présente invention est mise en oeuvre dans une chambre dont l'air a été évacué et que l'on remplit ensuite d'un gaz inerte afin d'éviter l'oxydation de la soudure et des doigts de contact et de prévenir la carbonisation et la cassure du flux employé pour réaliser la soudure. Etant donné qu'il est indispensable de mettre en oeuvre le procédé de la présente invention dans une chambre étanche et que, de ce fait, il n'est pas possible d'accéder facilement aux éléments sur lesquels on travaille, une efficacité maximum sera obtenue en automatisant ledit procédé. Etant donné que quelques-unes seulement des microplaquettes doivent être remplacées et que le fait de porter un substrat à des températures élevées risque d'endommager les microplaquettes qui se trouvent sur celui-ci, l'un des principaux avantages de la présente invention réside dans le fait qu'elle permet de porter une microplaquette donnée à une température suffisante pour qu'elle puisse être soudée à l'emplacement désiré sans pour autant chauffer indûment les microplaquettes voisines. Par ailleurs, le présent procédé tient compte du fait que l'on a découvert dans le cadre de la présente invention que les microplaquettes sont moins endommagées lorsqu'on les chauffe au moyen d'une source lumineuse dont les longueurs d'onde sont nettement plus courtes qu'une radiation infrarouge, lorsque la radiation est dirigée vers la surface supérieure de la microplaquette en silicium (ou autre élément analogue) et que la surface inférieur de cette dernière porte des circuits et des billes de soudure. Etant donné que le silicium est opaque aux longueurs d'onde les plus courtes, la radiation est absorbée par la surface supérieure de la microplaquette et directement convertie en chaleur sur cette même surface, si bien que les parties métalliques, les transistors et/ou les autres éléments des circuits sous-jacents se trouvent protégés. Un faisceau laser à ions d'argon à longueur d'onde courte est confiné à la superficie d'une microplaquette donnée que l'on désire souder à une emplacement déterminé et dirigé vers la surface supérieure (arrière) de celle-ci. La lumière laser est absorbée par cette surface supérieure et n'est pas transmise à travers le silicium de la microplaquette, pour lequel la longueur d'onde critique à laquelle son coefficient d'absorption est très élevé est de 11000 Å. La lumière a été choisie de telle sorte qu'elle présente une longueur d'onde à laquelle le silicium semble être opaque, c'est-à-dire que son coefficient d'absorption soit très élevé. Etant donné qu'aucune source importante de lumière non cohérente présentant des longueurs d'onde désirées n'a encore pu être déterminée, une source cohérente de lumière telle que celle d'un laser dont l'intensité peut être commandée au moyen d'un dispositif de contrôle de température, constitue la source préférée.

## Brève description des Figures

La Figure 1 représente schématiquement un dispositif à laser contrôlé par réactions permettant de lier une microplaquette à un substrat en utilisant un agencement classique de balayage mécanique (non représenté).

La Figure 2 est un graphique représentant la température en fonction du temps pour chauffer une microplaquette de manière à lier des billes de soudure à un substrat.

La Figure 3 représente schématiquement de façon plus détaillée une partie du dispositif de la Figure 1.

La Figure 4 est une vue de dessus d'une partie du dispositif de la Figure 1 comportant un agencement de balayage modifié comportant un miroir.

## Description d'un mode de réalisation de l'invention

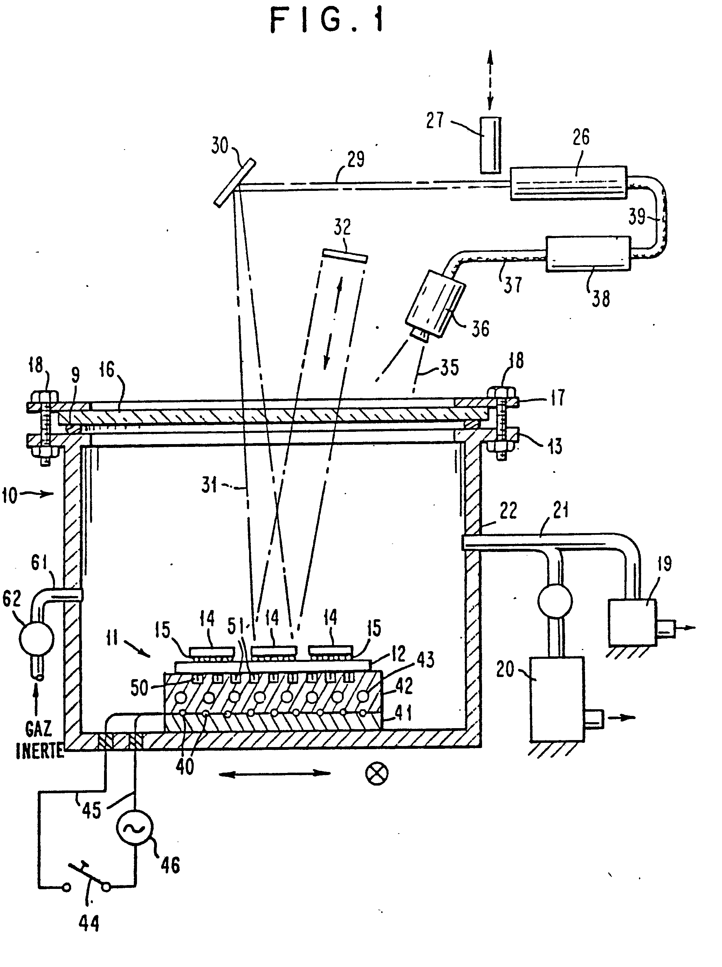

On a représenté sue la Figure 1 une chamber à vide 10 de forme cylindrique contenant un élément 11 servant de support à un module céramique 12 sur lequel se trouvent plusieurs microplaquettes à circuits multiples 14. Des microplaquettes 14 destinées à remplacer des microplaquettes défectueuses doivent être fixées électriquement et mécaniquement à des doigts de contact conducteurs sur le module céramique 12 au moyen de billes de soudure classiques 15.

De façon classique, le remplacement d'une microplaquette 14 défectueuse s'effectue en arrachant celle-ci du module puis en procédant à un nettoyage pour supprimer les parties restantes de la soudure sur les doigts de contact.

La présente invention concerne le remplacement d'une microplaquette défectueuse par une microplaquette présentant les mêmes caractéristiques, mais ne comportant aucun défaut. La microplaquette 14 que l'on désire fixer au module 12 comporte sous elle des billes de soudure 15 et du flux qui doivent être protégés contre l'oxydation, ainsi qu'on l'a précédemment indiqué. A cette fin, avant de lier la microplaquette 14 au module 12, on évacue la chambre à vide 10 au moyen d'une pompe 19, qui permet d'établir un vide primaire, et d'une pompe à diffusion 20, qui assure un vide secondaire, ces deux pompes étant reliées par des conduites 21 à la chambre 10. par l'intermédiaire d'une ouverture 22 pratiquée dans la paroi de celle-ci. On introduit ensuite dans la chambre 10, par l'intermédiaire d'une valve 62 et d'une conduite 61, un gaz inerte tel que de l'argon, de l'azote, de l'hydrogène, du néon, du xénon, du crypton, de l'hélium ou des mélanges de ces différents gaz, etc., afin de protéger les billes de soudure 15, les doigts de contact et le flux pendant l'opération de chauffage.

Les trois microplaquettes 14 de la Figure 1 représentent un grand nombre de microplaquettes disposées en rangées, dont seule la première est visible sur la figure. La microplaquette 14 qui se trouve au centre est celle que l'on est en train de lier au module 12 au moyen de la chaleur fournie par un faisceau laser 31 à section carrée, la microplaquette 14 étant elle-même de forme carrée (il est entendu que des microplaquettes de formes différentes seraient chauffées par des faisceaux laser de forme appropriée). La source du faisceau 31 est un laser 26, de préférence un laser à ions d'argon qui engendre une énergie présentant des longueurs d'onde comprises entre 4759 Å et 5145 Å. Ces longueurs d'onde sont si courtes que la microplaquette 14 comportant un substrat en silicium présente un coefficient d'absorption élevé d'environ $1,5 \times 10^4$ cm$^{-1}$ à ces longueurs d'onde. Cela signifie que la totalité de l'énergie incidente du faisceau laser 31 est absorbée par les dix premiers microns de l'épaisseur du substrat de la microplaquette 14. Etant donné que l'épaisseur totale de ce substrat est de plusieurs centaines de microns, les circuits qui se trouvent sur la surface inférieure de la microplaquette sont protégés contre toute chaleur excessive par la capacité importante d'absorption de l'énergie que présente le silicium de la microplaquette 14. Cette dernière est chauffée d'une façon relativement uniforme en raison de la forme du faisceau laser 31 et de l'absorption de chaleur qui se produit sur la surface supérieure de la microplaquette, surface depuis laquelle la chaleur est très rapidement transférée à la surface inférieure, la microplaquette étant extrêmement mince.

Ainsi qu'on l'a précédemment mentionné, la forme du faisceau laser 31 correspond à celle de la surface supérieure d'une microplaquette 14. Si cette dernière est carrée, on projette un faisceau laser 31 de forme carrée. Or, le faisceau 29 sortant du laser 26 est cylindrique et ne présente pas la variation gaussienne habituelle d'intensité des faisceaux laser réfléchis par un miroir, mais est d'intensité relativement uniforme dans toute la section transversale du faisceau. Ceci est effectué en remplaçant les miroirs habituels par des miroirs plus concaves (réflecteurs) dans le laser 26 aux extrémités opposées de la source de lumière laser, le pouvoir réfléchissant du miroir arrière étant égal à 100% et celui du miroir avant à 85%. On utilisera de préférence une configuration homofocale dans laquelle la distance séparant les miroirs est égale à deux fois la distance focale.

Un miroir 30 faisant fonction d'intégrateur de faisceau est disposé de manière à recevoir le faisceau cylindrique 29 et à le réfléchir vers la microplaquette 14 après l'avoir converti en un faisceau de forme carrée 31. Dans le cas d'une microplaquette 14 de forme rectangulaire, le miroir 30 permet d'obtenir un faisceau rectangulaire présentant une intensité pratiquement uniforme dans toutes les parties de sa section.

Le faisceau 31 réfléchi par le miroir 30 parvient à la microplaquette 14 après avoir traversé une fenêtre transparente 16 (en fluorure de calcium ou en verre) qui est maintenue par un châssis métallique de forme annulaire 17 fixé à une embase 13 au moyen de boulons et d'écrous 18. Une fenêtre en fluorure de calcium 16 est employée lorsque la lumière infrarouge doit parvenir à un détecteur situé à l'extérieur de la chambre. Des joint d'étanchéité de type classique 9 constitués par un élastomère du type généralement employé dans les chambres à vide sont utilisés pour les besoins de la fixation de la plaque transparente 16 à l'embase 13. Une quantité substantielle de la lumière du faisceau 31 est réfléchie depuis la microplaquette 14 vers le miroir 32, qui est de préférence plat et réfléchit à son tour cette lumière vers la microplaquette de manière à préserver l'énergie. Tous les miroirs employés doivent être fortement réfléchissants à la fréquence laser utilisée. Le laser 26, le volet laser 27, les miroirs 30 et 32 sont fermement maintenus en place par des moyens non représentés qui seront évidents pour l'homme de l'art.

La chamber 10 et les pompes 19 et 20 sont disposées sur un piedéstal qui n'est pas représenté sur la figure et qui est monté de manière à pouvoir se déplacer horizontalement dans les directions mutuellement perpendiculaires x et y indépendamment en actionnant au moyen d'une manivelle un dispositif d'entraînement à vis de telle sorte qu'une microplaquette 14 donnée puisse se trouver au-dessous du faisceau 31.

Ainsi, le volet laser 27 se trouvant dans une position telle qu'il intercepte le faisceau 29, on peut déplacer la chambre 10 jusqu'á ce qu'elle se trouve dans la position requise pour que la microplaquette désirée puisse, une fois le volet 27 ouvert (position représentée sur la figure), être frappée par le faisceau 31 et chauffée de telle sorte qu'elle soit soudée au module 12.

C'est au niveau de sa surface supérieure que la microplaquette 14 atteint sa température maximum lorsqu'elle est frappée par le faisceau laser 31. Selon une autre caractéristique de la présente invention, la température de la surface supérieure de la microplaquette est contrôlée par un détecteur ou radiomètre infrarouge 36 (du type commercialisé par la firme Barnes Engineering). Ce détecteur présente une sensibilité maximum à la longueur d'onde appropriée dans la plage de longueurs d'onde des rayons infrarouges que l'on peut utiliser aux fins de la détection de la température désirée.

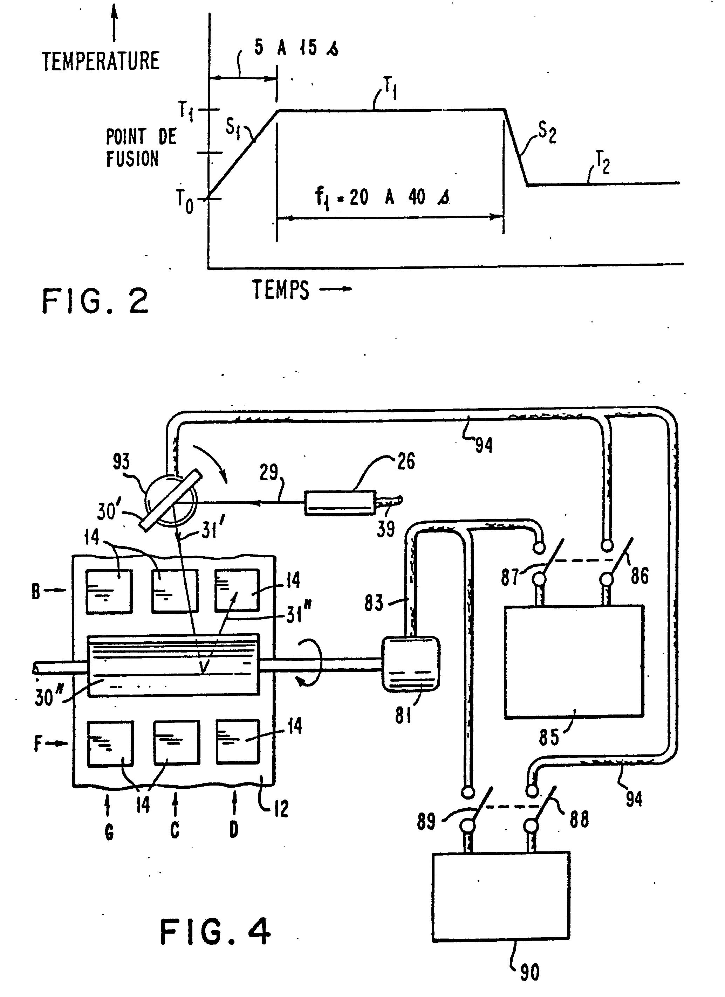

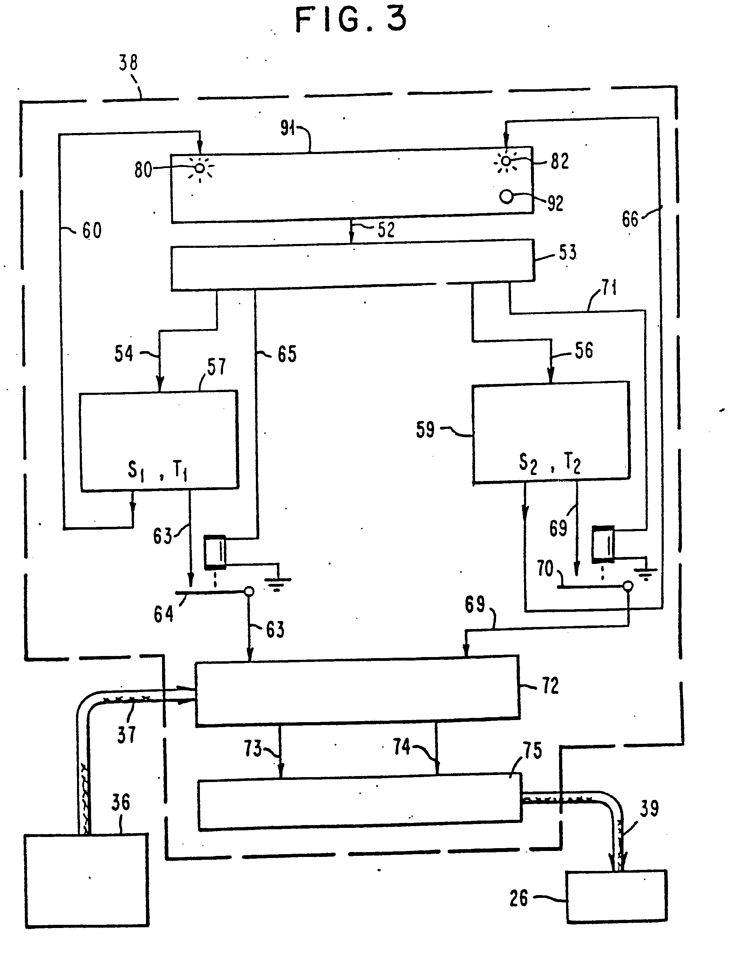

Le détecteur 36 fournit un signal de sortie qui varie en fonction de la température et qui est appliqué par l'intermédiaire d'un câble 37 à un dispositif de commande à réaction 38 connecté par l'intermédiaire d'un câble 39 au laser 26. Le dispositif 38 peut être programmé de manière à fournir un profil de température prédéterminé, tel le dispositif commercialisé sous l'appelation Eurotherm Controller qui est utilisable en milieu industriel et permet d'ajuster l'intensité de sortie du laser 26. Il existe un profil de température tel que celui représenté sur la Figure 2 qui permet d'augmenter, de la façon précédemment indiquée, la valeur du point de fusion des billes de soudure 15 de manière à éviter un choc thermique. La limite supérieure se situe de 20° à 50°C au-dessus du point de fusion des billes de soudure 15. Ainsi, la microplaquette 14 est automatiquement portée á la température désirée qui varie en fonction de l'intensité du faisceau laser 31 et de la durée de son application. Le dispositif 38 est décrit ci-après de façon plus détaillée à l'aide de la Figure 3.

Bien que le faisceau 31 ici représenté soit suffisamment large pour recouvrir la totalité de la microplaquette, il est préférable, lorsque les billes de soudure 15 occupent des positions irrégulières à la surface de la microplaquette, d'utiliser un faisceau laser mince (voir Figure 4) que l'on peut diriger uniquement vers certaines régions de la microplaquette au-dessous desquelles se trouvent les billes de soudure 15. Il est inutile en pareil cas de chauffer la totalité de la surface de la microplaquette 14 pour chauffer les billes 15. Par ailleurs, une analyse thermographique de photographies infrarouges de microplaquettes chauffées a permis de constater que, dans les régions dans lesquelles aucune bille de soudure n'existe au-dessous de la zone chauffée, il se produit une augmentation très substantielle de la température dans la microplaquette, ce qui est indésirable. Les billes de soudure 15 constituent évidemment un puits de chaleur excellent pour la dissipation de chaleur à partir de la surface inférieure de la microplaquette. De plus, le transfert de chaleur qui se produit latéralement dans la microplaquette est beaucoup plus lent que celui qui se produit au travers d'une microplaquette 14 mince. En pareil cas, il est nécessaire que le faisceau laser balaie rapidement la surface de la microplaquette à l'aide d'un miroir rotatif 30 commandé par calculateur, employé pour ne frapper que les régions désirées de la même façon que les systèmes de balayage à faisceau électronique sont utilisés pour exposer des films minces de résine photosensible ou pour procéder à un usinage. De la sorte, seules les régions qui ont besoin de chaleur recoivent celle-ci. Dans une telle réalisation, il est nécessaire de balayer plusieurs fois une microplaquette 14 avant que celle-ci ne soit suffisamment chauffée pour que la soudure puisse fondre et lier la microplaquette au module 12.

L'élément 11 servant de support comprend deux blocs 41 et 42 (constitués par du cuivre, de manière à obtenir une bonne conductivité thermique) qui sont réunis l'un à l'autre par brasage au cuivre et flux approprié. Le bloc supérieur 42 comporte des trous 50 destinés à recevoir les broches 51 qui se trouvent sur la partie inférieure du module 12. Des bobines de chauffage 40 sont maintenues en sandwich entre les deux blocs. Les bobines 40 permettent de porter le module 12 à une température d'environ 200° à 250°C avant l'application du faisceau laser, afin de réduire la quantité de chaleur que devra fournir le faisceau 31 pour faire fondre les billes de soudure 15. Cela permet de réduire le choc thermique subi par la microplaquette 14 et par le module 12. Les bobines 40 sont protégées électriquement du cuivre et de l'argent par une couche isolante. Le bloc 42 comporte des évidements 43 destinés á être remplis d'un produit de refroidissement. Les évidements 43 sont interconnectés (par des moyens non représentés) et sont reliés à une pompe et à un radiateur, de façon classique. Le produit de refroidissement que comportant les évidements 43 permet de refroidir rapidement le module 12 une fois que la microplaquette 14 a été reliée à celui-ci.

Le bloc 42 comprend un certain nombre de trous 50 dont les emplacements correspondent aux broches 51 disposées sur la partie inférieure du module 12. Cet agencement a pour but de créer un contact thermique optimum entre le bloc 42 et le module 12.

La bobine 40 est chauffée électriquement par une tension alternative fournie par une source 46, par l'intermédiaire de conducteurs 45 et d'un commutateur 44, lorsque celui-ci est fermé. Une fois que les microplaquettes ont été liées au moyen du laser, le commutateur 44 est ouvert et le produit de refroidissement circule dans les évidements 43.

Comme le montre la Figure 2, à laquelle on se reportera de nouveau, la température d'une microplaquette passe, depuis l'instant 0, d'une faible température $T_0$ à une température élevée $T_1$ pendant un intervalle de temps $S_1$ dont la durée est d'environ 5 à 15 secondes. Sa température reste ensuite à la valeur $T_1$ pendant un intervalle de temps $t_1$ de 20 à 40 secondes qui devrait suffire dans la plupart des cas pour obtenir une soudure adéquate. La température tombe ensuite au niveau $T_2$ qu'elle atteint après un intervalle de temps $S_2$. Lorsque ce dernier niveau a été atteint, la température de la microplaquette a été ramenée, par suite de refroidissement, à une valeur inférieure au point de fusion des billes de soudure 15 et le processus est essentiellement terminé.

La Figure 3 est un schéma synoptique du dispositif de commande 38, etc. Le détecteur ou radiomètre infrarouge 36 précédemment mentionné (et qui est également représenté sur la Figure 3) peut être d'un type quelconque capable de détecter l'état de la microplaquette 14 en fonction de la chaleur qui lui est transmise par le faisceau laser. Ce détecteur pourrait même être du type décrit dans l'article de S. I. Tan intitulé "Individual Chip Joining Monitor" paru dans la publication "IBM Technical Disclosure Bulletin", Vol. 21, No. 6, pages 2551—2552, Novembre 1978. Le détecteur décrit dans cet article utilise un réseau x-y de détecteurs qui permet de détecter le déplacement de la microplaquette lors de la fusion de la soudure.

Le dispositif 38 comprend un dispositif de commande programmé 91 comportant un commutateur de déclenchement 92 et des voyants lumineux de contrôle 80 et 82 qui sont commandés par l'intermédiaire de lignes 60 et 66 et qui montrent la partie du cycle de température de la Figure 2 actuellement en cours. Le dispositif 91 met en service, en transmettant un signal sur la ligne 52, une horloge 53 à cycle de répétition qui peut être ajustée manuellement. Cette horloge, par la ligne 54, excite un circuit 57, appelé programmateur à valeur pré-établie, qui est réglé de manière à permettre d'obtenir, selon la courbe $S_1$ la température $T_1$ à l'expiration d'un intervalle de temps prédéterminé manuellement de 5 à 15 secondes, ainsi qu'on l'a précédemment indiqué. La température $T_1$ est également prédéterminée manuellement au moyen d'une commande manuelle que comporte le circuit 57. La ligne 65 provenant de l'horloge 53 permet de connecter la ligne 63 à un comparateur 72 par l'intermédiaire d'un commutateur 64 pendant la montée en température (courbe $S_1$) et pendant l'intervalle de temps $t_1$ pendant lequel la température $T_1$ est maintenue. L'horloge 53 cesse ensuite d'exciter la ligne 54 et remet à son point de départ le programmateur 57. A l'expiration de l'intervalle de temps $t_1$ le circuit 57 est déconnecté du comparateur 72 lorsque l'horloge 53 par l'ouverture du commutateur 64, déconnecte la ligne 65, tout en excitant, par la ligne 56, le circuit 59, appelé, comme le circuit 57, programmateur à valeur pré-établie, et la ligne 71 de manière à fermer le relais 70 et, de ce fait, à connecter la ligne 69 au comparateur 72 pendant la dernière partie du cycle de température ici décrit, c'est-à-dire pendant le refroidissement selon la courbe $S_2$ de la Figure 2 et le passage à la température $T_2$. Le circuit 59 maintient la température $T_2$ jusqu'à la fin du cycle et est ensuite restauré lorsque l'horloge 53 cesse d'exciter la ligne 56. Bien que divers autres cycles programmés puissent être utilisés, la description ci-dessus montre la façon dont une suite de signaux de commande de température de valeurs croissantes, fixe et décroissantes peut être engendrée pour commander un comparateur 72. Ce dernier reçoit la sortie du détecteur 36, qui est comparée avec le courant appliqué au comparateur par l'intermédiaire de la ligne 63 ou de la ligne 69. Si la température de la microplaquette est trop élevée, une sortie est engendrée sur la ligne 74 de manière à diminuer la valeur du signal appliqué au circuit de commande de sortie 75, qui ajuste la valeur du signal appliqué à l'alimentation du laser 26. Si, au contraire, le comparateur 72 constate que le signal présent sur le câble 37 est inférieur au signal présent sur la ligne d'entrée 63 ou 69, un signal est transmis sur la ligne 73 et provoque une augmentation, par le circuit 74, de la valeur du signal appliqué à l'alimentation du laser 26.

La Figure 4 est une vue de dessus partielle de la structure représentée sur la Figure 1 et modifiée de telle sorte qu'elle comprend un dispositif de balayage à miroir dans lequel deux miroirs sont entraînés alternativement de façon manuelle ou sous le contrôle d'un calculateur (microprocesseur). La Figure représente une partie, telle qu'elle peut être vue au travers de la plaque transparente 16, d'un module céramique 12 comportant plusieurs microplaquettes 14, qui peuvent être beaucoup plus nombreuses que celles ici représentées, dans les directions verticale et horizontale. Un mince faisceau laser 29 est dirigé vers un miroir 30' qui est légèrement incliné autour d'un axe vertical et dirige le faisceau réfléchi 31' vers la droite de telle sorte qu'il frappe un autre miroir, 30", qui est très rapproché du précédent et qui est légèrement incliné autour d'un axe horizontal dans le plan de la page parallèlement au faisceau laser 29, si bien qu'un faisceau doublement réfléchi, 31", frappe la microplaquette 14 supérieure droite dans la rangée arrière B (laquelle n'est pas visible sur la Figure 1 puisque cette dernière est une coupe). En agissant sur le miroir 30', on peut balayer toutes les microplaquettes de cette rangée B, ce balayage pouvant avoir lieu de façon rectiligne de droite (D) à gauche (G) en passant par le centre (C) si le miroir 30" reste fixe. En revanche, si le miroir 30' reste fixe, le balayage peu avoir lieu le long de la colonne D, depuis la rangée B jusqu'à la rangée F ou toute autre rangée (non représentée) désirée. En agissant simultanément ou séparément sur les miroirs 30' et 30" selon une séquence appropriée, on peut obtenir un balayage combiné dans les directions x et y, de la même façon que dans les traceurs de courbes de calculateur, bien connus, de telle sorte que le balayage puisse être effectué en ligne droite ou suivant des courbes complexes. Pour agir sur le miroir 30' (direction x), on utilise un moteur d'entraînement 93 qui est connecté par un câble 94 et un commutateur 86 ou 88 à un calculateur 85 ou à une unité de commande manuelle 90. De même, le miroir 30" est entraîné par un moteur 81 qui est connecté par un câble 83, lui-même connecté par l'intermédiaire d'un commutateur 89 ou 87 à l'unité 90 de commande manuelle ou au calculateur 85, respectivement. Les moteurs 93 et 81 sont excités en mode synchrone lorsque les commutateurs 88 et 89 sont fermés, ce qui permet à un opérateur qui supervise manuellement l'ensemble du processus d'agir sur la commande manuelle 90. En revanche, dans le cas d'un fonctionnement automatique, ces deux moteurs sont excités en mode pas à pas. Les moteurs 93 et 81 peuvent être connectés à un même arbre afin de pouvoir être utilisés de façon alternée durant le développement des commandes appropriées du procédé aux fins d'un traitement optimum des microplaquettes 14 présentant une configuration donnée, ou bien lorsqu'une unique microplaquette doit être retirée sous contrôle manuel au lieu de charger des informations de commande dans le microprocesseur 85. La technique de commande la plus simple consiste évidemment à faire tourner les deux miroirs 30' et 30" au moyen de boutons molletés (non représentés) sur les arbres auxquels ils sont connectés. Le balayage doit de préférence être effectué en fractions de seconde et répété sur toutes les lignes requises pour chauffer les différentes rangées de billes de soudure 15 disposées au-dessous d'une microplaquette 14 donnée. Ainsi, la technique la plus efficace consiste à procéder au balayage à l'aide du calculateur 85, qui peut entraîner les moteurs pas à pas 93 et 81 à un rythme extrêmement rapide.

On a essayé, avec un succès limité, de remplacer les lasers en tant que sources de chaleur par diverses autres sources d'énergie cohérente et non cohérente. On se servait jusqu'à présent à cette fin d'une ampoule de projection photographique, mais celle-ci devait être disposée à une si faible distance qu'elle rendait tout contrôle impossible et, de ce fait, ne permettait pas de commander le niveau d'énergie. On a également utilisé une miniflamme d'oxyhydrogène. Les lampes à arc au xénon sont insatisfaisantes parce qu'elles utilisent une puissance de 10 kW qui doit être focalisée sur une ouverture de très faibles dimensions et parce que les filtres employés réduisent davantage encore l'intensité disponible.

Pour pouvoir appliquer avec succès un laser à la résolution de ce problème, il est nécessaire de combiner un grand nombre de facteurs complexes afin d'obtenir le dispositif ici décrit.

Les radiations ultra-violettes sont également indésirables en raison de leurs effets délétères sur le flux. Une source à bande étroite est donc préférable et un laser utilisé à la fréquence requise est idéal.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du champ de la protection accordé par les revendications.

## Revendications

1. Dispositif pour fixer une microplaquette (14) comportant des circuits sur sa surface inférieure ainsi que des régions comportant de la soudure, à des doigts de contact sur un substrat (12), caractérisé en ce qu'il comprend une chambre étanche (10) contenant un gaz inerte dans laquelle sont disposés la microplaquette et le substrat et des sources d'énergie (26) permettant de diriger des radiations (31) à des longueurs d'onde auxquelles la microplaquette est pratiquement opaque, vers la surface supérieure de celle-ci.

2. Dispositif selon la revendication 1, caractérisé en ce qu'il comprend des moyens (36) permettant de détecter la température de ladite microplaquette, des moyens de commande à réaction (38) dont une entrée est commandée par lesdits moyens de détection et possédant une sortie permettant d'ajuster l'intensité des sources d'énergie (26) afin d'ajuster l'intensité des radiations qui en émanent.

3. Dispositif selon la revendication 1 ou 2, caractérisé en ce que des miroirs de balayage (30', 30") sont disposés entre les sources d'énergie (26) et ladite microplaquette (14) et permettent de balayer, au moyen de ladite radiation (31', 31") transportant l'énergie, ladite microplaquette selon une suite prédéterminée de balayages suivant des parcours prédéterminés.

4. Dispositif selon l'une des revendications 1 à 3, caractérisé en ce que les sources d'énergie se composent d'un laser à ions d'argon.

5. Procédé pour fixer une microplaquette (14) comportant des circuits sur sa surface inférieure ainsi que des régions comportant de la soudure, à des doigts de contact sur un substrat (12), caractérisé en ce qu'il consiste:

à disposer la microplaquette et le substrat dans une chambre étanche (10) contenant un gaz inerte, et

à diriger des radiations (31) présentant des longueurs d'onde auxquelles ladite microplaquette est pratiquement opaque vers la surface supérieure de celle-ci.

6. Procédé selon la revendication 5, caractérisé en ce qu'il comprend la détection de la température de la microplaquette (14) et l'adjustement de l'intensité desdites radiations (31) en fonction de cette température.

7. Procédé selon la revendication 5 ou 6, caractérisé en ce qu'il consiste à utiliser des miroirs de balayage (30', 30") disposés sur le trajet des radiations (31', 31") de manière à assurer le balayage de ladite microplaquette au moyen desdites radiations selon une suite prédéterminée de balayages le long de chemins prédéterminés.

8. Procédé selon l'une des revendications 5 à 7, caractérisé en ce que lesdites radiations sont constituées par un faisceau laser à ions d'argon.

## Patentansprüche

1. Vorrichtung zum Befestigen eines mit Schaltungen auf seiner Unterseite sowie Lötbereichen versehenen Halbleiterplättchens (14) auf Lötstützkontakten auf einem Substrat (12), dadurch gekennzeichnet, daß sie eine mit inertem Gas gefüllte, abgedichtete Kammer (10) zum Anordnen des Halbleiterplättchens, des Substrats und der Energiequellen (26) vorsieht, mit denen Strahlung (31) mit Wellenlängen, bei denen das Halbleiterplättchen praktisch undurchsichtig ist, auf die Oberseite desselben gerichtet werden können.

2. Vorrichtung nach Anspruch 1, dadurch gekennzeichnet, daß sie Mittel (36) zum Abfühlen der Temperatur des Halbleiterplättchens einschließt, wobei Rückkopplungssteuermittel (38) einen Eingang aufweisen, der von diesen Abfühlmitteln gesteuert wird, und einen Ausgang, der das Einstellen der Intensität der Energiequellen (26) ermöglicht, um die Intensität der davon ausgesandten Strahlung einzustellen.

3. Vorrichtung nach Anspruch 1 oder 2, dadurch gekennzeichnet, daß Rasterspiegel (30', 30") zwischen den Energiequellen (26) und dem Halbleiterplättchen (14) angeordnet sind, die es mit Hilfe der energieführenden Strahlung (31', 31") ermöglichen, das Halbleiterplättchen nach einer vorbestimmten Folge von Abtastungen entlang einem vorbestimmten Weg zu rastern.

4. Vorrichtung nach einem der Ansprüche 1 bis 3, dadurch gekennzeichnet, daß die Energiequellen aus einem Argon-Ionen-Laser bestehen.

5. Verfahren zum Befestigen eines mit Schaltungen auf seiner Unterseite sowie Lötbereichen versehenen Halbleiterplättchens (14) auf Lötstützkontakten auf einem Substrat (12), dadurch gekennzeichnet, daß es darin besteht:

das Halbleiterplättchen und das Substrat in einer mit inertem Gas gefüllten abgedichteten Kammer (10) anzuordnen, und

Strahlung (31) mit Wellenlängen, bei denen das Halbleiterplättchen praktisch undurchsichtig ist, auf die Oberseite desselben zu lenken.

6. Verfahren nach Anspruch 5, dadurch gekennzeichnet, daß es das Abfühlen der Temperatur des Halbleiterplättchens (14) und das Einstellen der Intensität der Strahlung (31) in Abhängigkeit von dieser Temperatur einschließt.

7. Verfahren nach Anspruch 5 oder 6, dadurch gekennzeichnet, daß es darin besteht, auf dem Weg der Strahlung (31', 31") angeordnete Rasterspiegel (30', 30") zu benutzen, um das Rastern des Halbleiterplättchens mit Hilfe der Strahlungen nach einer vorbestimmten Folge von Abtastungen entlang vorbestimmter Wege zu ermöglichen.

8. Verfahren nach einem der Ansprüche 5 bis 7, dadurch gekennzeichnet, daß die Strahlung aus einem Laserbündel aus Argon-Ionen besteht.

**Claims**

1. A device for fixing a chip (14), having circuits on its lower surface and solder regions, onto contact pads on a substrate (12), characterized in that it comprises an air-tight chamber (10) containing an inert gas, in which are arranged the chip and the substrate and energy sources (26) directing radiations (31) onto the upper surface of the chip at wave lengths where the latter is substantially opaque.

2. A device according to claim 1, characterized in that it comprises means (36) for detecting the temperature of said chip, feedback control means (38) having an input controlled by said detection means and having an output permitting the control of the intensity of the energy sources (26) for controlling the intensity of the radiations they emit.

3. A device according to claim 1 or 2, characterized in that scan mirrors (30', 30") are arranged between the energy sources (26) and said chip (14) so as to permit scanning, by means of said energy-carrying radiation (31', 31"), of said chip according to a predetermined sequence of scans along predetermined paths.

4. A device according to any one of claims 1 to 3, characterized in that the energy sources consist of an argon ion laser.

5. A method for fixing a chip (14), having circuits on its lower surface as well as solder regions, onto contact pads on a substrate (12), characterized in that it includes the steps of:

placing the chip and the substrate into an air-tight chamber (10) containing an inert gas, and

directing radiations (31) having wave lengths at which said chip is substantially opaque onto the upper surface of the latter.

6. A method according to claim 5, characterized in that it comprises the detection of the temperature of the chip (14) and the control of the intensity of said radiations depending on this temperature.

7. A method according to claim 5 or 6, characterized in that it uses scan mirrors (30', 30") arranged on the path of the radiations (31', 31") so as to ensure scanning of said chip by means of said radiations according to a predetermined sequence of scans along predetermined paths.

8. A method according to any one of claims 5 to 7, characterized in that said radiations consist of an argon ion laser beam.

**0013345**

# FIG.1

FIG. 2

FIG. 4

# FIG. 3